Europäisches Patentamt

European Patent Office

Office européen des brevets

(11) Publication number: **0 216 079**
**B1**

# (12) EUROPEAN PATENT SPECIFICATION

(45) Date of publication of patent specification: **10.01.90**

(51) Int. Cl.[5]: **C 23 C 14/06**

(21) Application number: **86110505.4**

(22) Date of filing: **30.07.86**

(54) Manufacturing method of carbon film and use thereof.

(30) Priority: **05.08.85 JP 173005/85**

(43) Date of publication of application:
**01.04.87 Bulletin 87/14**

(45) Publication of the grant of the patent:
**10.01.90 Bulletin 90/02**

(84) Designated Contracting States:
**DE FR GB NL**

(56) References cited:
**EP-A-0 022 285**
**EP-A-0 102 328**
**FR-A-2 364 273**

**IBM TECHNICAL DISCLOSURE BULLETIN, vol.
17, no. 8, January 1975, page 2475, New York,
US; K.Y.AHN et al.: "Barrier layer for magnetic
bubble domain film device applications"**

**CHEMIE-INGENIEUR-TECHNIK, vol. 41, no. 13,
July 1969, pages 780-781, Weinheim, DE;
B.LERSMACHER et al.: "Pyrolytischer Graphit
und glasartige Kohle"**

(73) Proprietor: **Kao Corporation
14-10, Nihonbashi Kayabacho 1-chome
Chuo-Ku Tokyo 103 (JP)**

(72) Inventor: **Yamauchi, Michihide
1450 Nishihama
Wakayama-shi Wakayama (JP)**
Inventor: **Kishine, Nobuyuki
1022-88 Himurocho
Utsunomiya-shi Tochigi (JP)**

(74) Representative: **Dipl.-Ing. H. Marsch Dipl.-Ing. K.
Sparing Dipl.-Phys.Dr. W.H. Röhl Patentanwälte
Rethelstrasse 123 Postfach 14 02 68
D-4000 Düsseldorf (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates to the use of a thin carbon film on the surface of a sliding member which slidingly contacts with another member and to a method of forming such a film.

EP—A—0 102 328 describes a low-pressure "cold" sputtering process with a glassy carbon target for manufacturing a coating of carbonaceous material onto prosthetic components.

From IBM Technical Disclosure Bulletin vol. 17, No. 8, January 1975, page 2475 the production of amorphous carbon films by radio frequency sputtering from a vitreous carbon target is known which films are used as barrier layers in magnetic bubble domain film devices.

This invention is applicable to a magnetic recording medium of an information processing system, artificial joints, sliding members of solenoid controller valves, etc.

In recent years recording/reproducing devices which use a recording medium with magnetic layers provided on a sheet of film or paper recording medium are widely available in market. These recording/reproducing devices incorporate various members which either constantly or temporarily slide over or contact with the recording medium. They are exemplified by a head slider in a flexible disc, a flying slider in a hard disc, a magnetic head, etc. They are required to have an excellent durability and not to damage the recording medium with which they contact slidingly.

The members which are often subjected to sliding contacts such as the mechanical seal, electromagnetic valve sliding members, or artificial joints are required to impart slidability on the surface of members having the structural strength. More particularly, they should have such properties as small frictional coefficient and high durability and they give no damages to the opposing members with which they slidingly contact.

Much efforts have been made in the field of surface chemistry in order to obtain such desirable slidability. Attempts were made to prevent damages on the recording media by providing a protective film on a recording medium or coating lubricant either on the recording medium or on the surface of a member which slidingly contacts with the medium in the devices for driving flexible discs or hard discs.

The use of lubricant, however, is not desirable in that the effect thereof deteriorates chronologically. In order to make the effect last, it is necessary to coat the members with lubricant periodically.

Examples of protective film have been disclosed in Japanese Patent Application Disclosures No. 83829 of 1981 and No. 83869 of 1981 in which film of alumina, silica or barium titanate is formed on the magnetic head, but the durability of the recording medium was not yet sufficient.

From EP—A—0022285 it is known to improve the friction properties of a sliding member in dry sliding by forming a thin, diamond like carbon layer on the sliding surface of said member.

A protective film is sometimes formed on the surface of a recording medium wherein silica or carbon is used as the material. They, however, tend to deteriorate the characteristics of the recording medium underneath the protective film and yet fail to produce satisfactory slidability.

An object of this invention is to provide a carbon film which has less friction resistance against the members with which the film slidingly contacts, and more particularly to form a carbon film on the surface of a magnetic recording medium without damaging the magnetic layers and the characteristics thereof.

Therefore, the present invention concerns the use of a thin and substantially amorphous carbon film with low friction resistance on the surface of a sliding member formed of a magnetic recording medium, wherein glass-like carbon is used as the carbon source and wherein the thin carbon film is deposited onto said surface by sputtering from said carbon source.

The obtained thin carbon film which has a high durability and yet does not damage the substrates thereof and another member with which the coated member slidably contacts.

"Sputtering" as used herein means a method of causing ions to strike on a target substance, vaporizing atoms or molecules from the target surface, and depositing thus vaporized atoms or molecules on the surface of the subject material. This invention does not place restrictions on the types of ions, the reaction atmosphere and/or the production method of ions, but it is desirable to use the low pressure sputtering method in view of the purity of the formed film and the speed of forming. The low pressure sputtering method conducts the process using the gas pressure during reaction which is lower than $10^{-1} \sim 10^{-2}$ Torr in the region where cold cathode glow discharge is maintained. As such a method, there have been known the Triode Direct Current Glow-discharge Sputtering, Diode Radiofrequency Glow-discharge Sputtering or Magnetron Sputtering.

As a carbon source, this invention uses glass-like carbon obtained by carbonizing a thermosetting resin, glass-like carbon obtained by carbonizing modified resins for thermo-setting by copolymerization and copolycondensation, glass-like carbon obtained by chemically preventing crystallization in the process of setting or carbonizing, or glass-like carbon obtained by thermo-decomposing in vapor phase low molecule hydrocarbons such as methane, ethylene, benzene, etc. They may specifically be glass-like carbons of polyacrylonitrile group, of rayon type, of pitch type, of lignin group, of phenol group, of furan group, of alkyd resin group, of unsaturated polyester group, or of xylene resin group.

It is more desirable to use the glass-like carbon obtained by carbonizing hardened resin mainly containing the mixture of three groups, i.e. phenol, fulfuryl alcohol and formalin.

Either hydrocarbon in gaseous phase or a carbon material in bulk form may be used as the carbon source when this method is used for forming a thin carbon film on the surface of substrates or members

2

which slidingly contact with others.

As a method using hydrocarbons in gaseous phase, there has been known the chemical vapor deposition method (CVD) which produces carbons by thermo-decomposition under the thermal equilibrium or the method to separate carbons by disturbing the thermal equilibrium in some way or by forcibly making thermally unbalanced state. The latter method is exemplified by the plasma CVD method or the ionization deposition method which uses hydrocarbons such as methane. However, as the temperature range to effect thermal decomposition is 600°C—800°C or higher in the above method, it may present a problem in the thermal resistance of substrates or in the thermal influence on the magnetic materials when forming a thin film on a magnetic recording medium. The method is further defective in that it cannot form a uniformly thin film over a large area. Although the plasma CVD method or ionization deposition method can produce hard carbon films, the film is not sufficiently uniform. If they are to be made uniform, the process needs expensive devices.

As the method for using carbon materials in bulk form as the carbon source, there has been known such method as the vacuum deposition method or sputtering method. However, if a thin film is formed by the vacuum deposition, the comparatively low kinetic energy of particles to be deposited causes the formed film to be easily peeled and renders durability inferior. The thin film formed by the vacuum deposition method is generally non-uniform and the film pressure is not uniform, either.

Besides above methods, the ion plating method is also known, but it requires expensive devices.

In contrast to the above methods, the sputtering method can form a film of a uniform thickness. The study conducted by the inventors of this invention revealed that when a thin carbon film is formed by the sputtering method, the formed film has correlation with the structure of the target material. More particularly, when glass-like carbon is used as a target in sputtering, the thin carbon film formed is substantially amorphous, uniform and highly durable. It was found that if glass-like carbon having an extremely small number of surface voids is used, the time required to reach the background pressure for sputtering of $1 \times 10^{-7}$ Torr can be shortened, and moreover, impurity gas and carbon powder can be prevented during or before/after the sputtering step.

The thin film carbon obtained by the present invention method is effective in improving the durability of the sliding members as well as in reducing the friction coefficient of the members which slidingly contact with the sliding member. Therefore, if such a thin carbon film is applied for the surface protective film on a hard disc, electromagnetic valve sliding surface, artificial joint sliding surface, etc., it can achieve remarkable effects.

This invention will now be described in more detail by referring to preferred and comparative examples. The examples shown below are mere examples and are not intended to restrict the technical scope of this invention in any way. Although the case wherein a thin carbon film is formed on a hard disc for a magnetic recording device is illustrated in the following examples and comparisons, this invention can well be practiced with other materials and other members. All the "parts" mentioned in the following description means parts by weight.

## Example 1

Phenol modified furan resin containing furfuryl alcohol, paraformaldehyde and phenol adjusted to be 30:40:30 in mole ratio is prepared by the usual method to obtain 800 cps liquid resin. To the resin obtained is added 2.5 parts of 60% p-toluenesulfonate aqueous solution, and the resultant mixture is sufficiently agitated and a disc type hardened resin is molded in the thickness of 3.5 mm. The hardened resin is heated to 1,100°C in nitrogen atmosphere at the rate of 2°C/hr., retained for two hours, and then cooled to obtain glass-like carbon.

Thus obtained glass-like carbon is mounted on a backing plate and used as a target for sputtering. A disc substrate manufactured by Sumitomo Light Metal Industries Ltd. which is formed by sputtering a Co-Cr alloy film of 0.5 μm thickness on an aluminum substrate of 5.25 inch diameter is used as the substrate to be deposited with film. The sputtering device used was NICHIDEN ANELVA SPF 530. As is generally conducted in sputtering, vacuum of $1 \times 10^{-7}$ Torr was created as the background pressure, argon gas was filled up to $2 \times 10^{-3}$ Torr, the backing plate was cooled with water, and high frequency power of 400W was applied for sputtering. The thickness of the film being formed was monitored by a film thickness meter of Quartz resonator while forming a thin carbon film of 400Å.

When observed with X-ray diffraction for thin film, Raman spectroscope and transmission electron microscope image, the formed carbon film was disclosed to be substantially amorphous.

## Example 2

A glass-like carbon (Glahard S manufactured by Kao Corporation) was used as a target and sputtering was conducted as in Example 1 except that the background pressure was $1 \times 10^{-7}$ Torr, argon gas pressure $3 \times 10^{-3}$ Torr and high frequency power 300 W. As a result, a thin carbon film having the thickness of 350Å was formed on the surface of a disc substrate. Measurement identical to the Example 1 revealed that the formed carbon film was substantially amorphous.

## Example 3

A glass-like carbon (Glahard R manufactured by Kao Corporation) was used as a target and sputtering was conducted as in Example 1 except that the background pressure was $1 \times 10^{-7}$ Torr, argon gas pressure

$3 \times 10^{-3}$ Torr and high frequency power 500 W. As a result, a carbon film having thickness of 400Å was formed on the surface of a disc substrate.

## Comparative Example 1

Graphite ("Metaphite MF—301" manufactured by Tohoku Kyowa Carbon) was used as a target and sputtering was conducted as in Example 1 except that the background pressure was $1 \times 10^{-7}$ Torr, argon gas pressure $3 \times 10^{-3}$ Torr and high frequency power 500 W. A carbon film having the thickness of 400Å was formed on the surface of a disc substrate. In this example, the thickness of the film was measured by surface roughness meter.

## Example 4

Hardened resin containing furfuryl alcohol, paraformaldehyde and phenol at the molar ratio of 35:40:35 was used as the material, and carbonizing and sputtering as in Example 1 were conducted. A carbon thin film having the thickness of 400Å was obtained.

## Example 5

Hardened resin containing furfuryl alcohol, paraformaldehyde and phenol at the molar ratio of 5:55:40 was used as the material, and carbonizing and sputtering as in Example 1 were conducted. A carbon film having the thickness of 400Å was formed.

## Example 6

Hardened resin containing furfuryl alcohol, paraformaldehyde and phenol at the molar ratio of 50:30:20 was used as the material, and carbonizing and sputtering as in Example 1 were conducted. A carbon film having the thickness of 400Å was formed.

## Example 7

The hard resin obtained in Example 2 was heated to 600°C at the heating rate of 2°C/hr in the nitrogen gas current, and was retained for two hours. The carbonized product was measured quantitatively with an element analyzer to reveal 92.5 weight % of carbon. Using thus obtained carbonized product, sputtering was conducted as in Example 1 to form a carbon film having the thickness of 400Å.

## Comparative Example 2

Using $SiO_2$, sputtering target material which is commercially available, oxygen gas current was introduced to the atmosphere with the background pressure of $1 \times 10^{-7}$ Torr and argon gas pressure of $3 \times 10^{-3}$ Torr, and bias sputtering was conducted under the high frequency power of 500 W. As a result, an $SiO_2$ film was formed on the surface of a disc substrate.

## Test Example

The friction coefficients of the carbon films obtained in Examples 1 through 7 and Comparative Examples were measured by a pin-on-disc type friction coefficient measuring apparatus. Mn-Zn ferrite chips which are usually used as the material for magnetic heads are used as pins.

The contact-start-stop (CSS) test was repeated for 20,000 times by mounting disc substrates on which carbon films were formed in Examples 1 through 7 and Comparative Examples 1 and 2 on a driving device of a cartridge type hard disc, and repeating the rising and landing of the magnetic head on a predetermined track. The damages made on the substrate surfaces and head surface which are slidingly contacting with each other were observed by a scanning electron microscope. The result is listed in the table. The table also shows changes on the magnetic characteristics of the magnetic film underneath substrate (the magnetic retention Hc and the strength of anisotropic magnetic field Hk) caused by the formation of the protective film. From the table, it is clear that the thin films obtained by sputtering with a glass-like carbon as a target did not show deteriorated characteristics of the magnetic film of the substrate, had excellent durability and had a low friction coefficient.

| | Dynamic friction coefficient | CSS test | | Magnetic characteristics | |
|---|---|---|---|---|---|
| | | disc surface | Head surface | Hc [Oe] | Hk [Oe] |
| Example 1 | 0.11 | Excellent | Excellent | 400 | 2100 |
| Example 2 | 0.12 | Excellent | Excellent | 405 | 2100 |
| Example 3 | 0.13 | Excellent | Excellent | 401 | 2100 |
| Example 4 | 0.12 | Excellent | Excellent | 402 | 2100 |
| Example 5 | 0.14 | Good | Excellent | 400 | 2100 |
| Example 6 | 0.14 | Good | Excellent | 401 | 2100 |
| Example 7 | 0.20 | Film is partially peeled off. | Slightly stained. | 406 | 2100 |
| Comparative example 1 | 0.14 | Film is partially peeled off. | Good | 440 | 1900 |
| Comparative example 2 | 0.27 | Film surface is damaged. | Cracked | 450 | 1950 |
| Without protective film | — | Magnetic surface is damaged. | Cracked | 400—410 | 2100 |

## Claims

1. The use of a thin and substantially amorphous carbon film with low friction resistance as a protective casing on the surface of a sliding member formed of a magnetic recording medium, especially a hard disc of a magnetic recording device, wherein said thin carbon film is formed on said surface by a sputtering process with a glass-like carbon material as the carbon source (target).

2. The use of a carbon film as defined in claim 1, characterized in that as glass-like carbon a carbonized product of hard resin containing phenol, furfuryl alcohol and formalin as principal constituents is used.

3. The use of a carbon film as defined in claim 1 or 2, characterized in that the sputtering is conducted within an atmosphere lower than the gas pressure which can maintain cold-cathode glow-discharge.

4. The use of a carbon film according to one of the claims 1 to 3, characterized in that a glass-like carbon having an extremely small number of surface voids is used as a target in sputtering.

## Patentansprüche

1. Verwendung eines dünnen und im wesentlichen amorphen Kohlenstoffüberzugs mit geringem Reibungswiderstand als Schutzschicht auf der Oberfläche eines leitenden Teils eines magnetischen Aufzeichnungsmediums, insbesondere einer Festplatte einer magnetischen Aufzeichnungseinrichtung, wobei der besagte dünne Kohlenstoffilm auf der besagten Oberfläche durch einen Zerstäubungsvorgang mit einem glasartigen Kohlenstoffmaterial als Kohlenstoffquelle (Target) gebildet ist.

2. Verwendung eines Kohlenstoffilms wie in Anspruch 1 definiert, dadurch gekennzeichnet, daß als glasartiger Kohlenstoff ein karbonisiertes Produkt eines Hartharzes, enthaltend Phenol, Furfurylalkohol und Formalin als Hauptbestandteile, verwendet wird.

3. Verwendung eines Kohlenstoffilms wie in Anspruch 1 oder 2 definiert, dadurch gekennzeichnet, daß das Zerstäuben in einer Atmosphäre mit einem Druck geringer als der Gasdruck, der eine Kaltkathodenglimmentladung aufrechterhalten kann, durchgeführt wird.

4. Verwendung eines Kohlenstoffilms nach einem der Ansprüche 1 bis 3, dadurch gekennzeichnet, daß ein glasartiger Kohlenstoff, der eine extrem kleine Anzahl von Oberflächenporen aufweist, als Target beim Zerstäuben verwendet wird.

## Revendications

1. Utilisation d'une pellicule de carbone substantiellement amorphe et mince présentant une faible résistance au glissement d'un rvêtement de protection sur la surface d'un élément de glissement formé d'un moyen d'enregistrement magnétique, spécialement un disque dur d'un dispositif d'enregistrement magnétique, tel que ladite pellicule fine de carbone est formée sur ladite surface par un procédé de pulvérisation cathodique utilisant une matière de carbone du type vitreux comme source de carbone (cible).

2. Utilisation d'une pellicule de carbone selon la revendication 1, caractérisée en ce qu'on utilise comme carbone du type vitreux un produit carbonisé d'une résine dure contenant du phénol, de l'alcool furfurylique et de la formaline comme constituants principaux.

3. Utilisation d'une pellicule de carbone selon l'une des revendications 1 et 2, caractérisée en ce que la pulvérisation cathodique est réalisée dans une atmosphère plus basse que la pression gazeuse qui peut maintenir un tube à décharge lumiscente.

4. Utilisation d'une pellicule de carbone selon l'une des revendications 1 à 3, caractérisée en ce qu'on utilise un carbone du type vitreux présentant un nombre extrêmement petit de vides de surface comme cible pour la pulvérisation cathodique.